(19) Europäisches Patentamt
European Patent Office
Office européen des brevets

(11) **EP 3 351 949 B1**

(12) **EUROPÄISCHE PATENTSCHRIFT**

(45) Veröffentlichungstag und Bekanntmachung des Hinweises auf die Patenterteilung:
**21.08.2019  Patentblatt 2019/34**

(51) Int Cl.:
*G01R 31/02* *(2006.01)*      *G01R 31/08* *(2006.01)*

(21) Anmeldenummer: **17151996.0**

(22) Anmeldetag: **18.01.2017**

(54) **VERFAHREN UND EINRICHTUNG ZUM ERMITTELN DES FEHLERORTES EINES ERDSCHLUSSES BEZÜGLICH EINER LEITUNG EINES DREIPHASIGEN ELEKTRISCHEN ENERGIEVERSORGUNGSNETZES MIT NICHT GEERDETEM STERNPUNKT**

METHOD AND DEVICE FOR DETERMINING THE ERROR LOCATION OF AN EARTH FAULT RELATING TO A LINE OF A THREE PHASE ELECTRICAL ENERGY SUPPLY NETWORK WITH NON-GROUNDED STAR POINT

PROCÉDÉ ET DISPOSITIF DE DÉTERMINATION DE L'EMPLACEMENT D'UN DÉFAUT À LA TERRE PAR RAPPORT À UNE CONDUITE D'UN RÉSEAU D'ALIMENTATION ÉLECTRIQUE TRIPHASÉ AYANT UN POINT EN ÉTOILE NON MIS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.07.2018  Patentblatt 2018/30**

(73) Patentinhaber: **Siemens Aktiengesellschaft 80333 München (DE)**

(72) Erfinder:
• **Dzienis, Cezary**
  **14624 Dallgow-Döberitz (DE)**
• **Jurisch, Andreas**
  **16727 Schwante (DE)**

(56) Entgegenhaltungen:
**US-A- 5 929 642     US-A1- 2011 098 951**

• **PATYNOWSKI DANIEL ET AL: "Fault Locator approach for high-impedance grounded or ungrounded distribution systems using synchrophasors", 2015 68TH ANNUAL CONFERENCE FOR PROTECTIVE RELAY ENGINEERS, IEEE, 30. März 2015 (2015-03-30), Seiten 302-310, XP032774097, DOI: 10.1109/CPRE.2015.7102173 [gefunden am 2015-05-05]**
• **ISTRATE M ET AL: "Assessment of fault location algorithms in transmission grids", POWERTECH, 2009 IEEE BUCHAREST, IEEE, PISCATAWAY, NJ, USA, 28. Juni 2009 (2009-06-28), Seiten 1-6, XP031543071, ISBN: 978-1-4244-2234-0**

**Beschreibung**

Die Erfindung betrifft ein Verfahren zum Ermitteln des Fehlerortes eines Erdschlusses bezüglich einer Leitung eines dreiphasigen elektrischen Energieversorgungsnetzes mit nicht niederohmig geerdetem Sternpunkt, bei dem an einem Leitungsende der Leitung Strom- und Spannungswerte gemessen werden, und unter Verwendung der gemessenen Strom- und Spannungswerte nach dem Auftreten eines Fehlers auf der Leitung dessen Fehlerort bestimmt wird. Die Erfindung betrifft auch eine entsprechende Einrichtung zum Ermitteln des Fehlerortes eines Erdschlusses.

Der sichere Betrieb elektrischer Energieversorgungsnetze erfordert die zuverlässige Erkennung und Abschaltung etwaiger Fehler, wie z.B. Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Nicht niederohmig geerdete Netze werden meistens auf der Verteilungsebene eines Energieversorgungssystems betrieben. Abhängig von der räumlichen Ausdehnung der Verteilungsebene werden diese Netze In zwei Varianten eingesetzt, einerseits mit isoliertem Sternpunkt, bei dem keinerlei Verbindung des Sternpunktes mit Erde vorliegt, und andererseits mit kompensiertem Sternpunkt, bei dem der Sternpunkt über eine Induktivität mit Erde verbunden ist. Im Folgenden ist der Ausdruck "nicht geerdet" im beschriebenen Sinne als "nicht niederohmig geerdet" zu verstehen.

Der Vorteil nicht geerdeter Netze besteht darin, dass sie während eines Erdschlusses grundsätzlich weiterhin betrieben werden dürfen und somit keine Unterbrechung der Energieversorgung vom Netz mit elektrischer Energie versorgter Lasten stattfindet. Darüber hinaus erlöschen Erdschlüsse meist von selbst, so dass keine Schalthandlung erforderlich ist.

Unabhängig davon, ob der Erdschluss längere Zeit ansteht oder von selbst erlischt, muss der Fehlerort, also diejenige Stelle auf der Leitung, an der der Erdschluss aufgetreten ist, identifiziert und von einem Wartungsteam überprüft werden, um etwaige mechanische Schäden zu erkennen und zu beheben. Eine nicht reparierte Erdschlussstelle kann nämlich auch zu einer mechanischen Schwächung führen, die sich bei einem unerwünschten Netzzustand (z.B. einer Spannungserhöhung) zu einem dauerhaften Kurzschluss ausweiten kann.

Um die Erdschlussstellen zu identifizieren, wird ein Fehlerortungsmechanismus benötigt, der als Ergebnis den Fehlerort, z.B. als Entfernung der Erdschlussstelle von einem Messgerät, ausgibt. Diese Stelle wird von einem Wartungsteam aufgesucht und auf mögliche Beschädigungen untersucht. Je genauer die Fehlerortung erfolgt, desto geringer sind die Aufwände zur Lokalisierung und Analyse der fehlerhaften Stelle der Leitung.

Im einfachsten, aber auch aufwendigsten, Fall findet eine Fehlerortung durch Inaugenscheinnahme statt. Dabei fährt das Wartungsteam die fehlerhafte Leitung ab und untersucht sie auf sichtbare Fehlerstellen. Diese Vorgehensweise ist langsam und fehleranfällig.

Im Fall von permanenten Erdschlüssen kann zudem durch kurzfristige Abschaltung von Leitungen geprüft werden, ob die Verlagerungsspannung im Netz nach Abschaltung einer Leitung verschwindet. Dieser Vorgang wird so lange fortgesetzt, bis die fehlerbehaftete Leitung gefunden wurde. Diese sogenannten Suchschaltungen sind aufwändig und verursachen während der Testabschaltungen Versorgungsausfälle.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht. Die Druckschrift US2011098951 A1 offenbart auch die Benutzung von Messwerten von beiden Leitungsenden. Die Messwerten werden unter Verwendung einer Clarke-Transformation verglichen.

Da in nicht geerdeten Netzen sehr geringe Erdschlussströme, die üblicherweise von deutlich größeren Betriebsströmen überlagert sind, sind sie mit konventionellen Methoden zur einseitigen Fehlerortung nur sehr schwer zu orten. In gelöschten Netzen werden Erdschlussstrome mit Löschspulen kompensiert. Darüber hinaus liegt die Erdschlussdauer von nicht permanenten Erdschlüssen (sogenannten Erdschlusswischern) unter eine Periodendauer, was die genaue Ermittlung von elektrischen Größen während des Fehlers, z.B. in Form komplexer Strom- oder Spannungszeiger, wesentlich erschwert. Die vorhandenen Transienten in den Messgrößen tragen auch dazu bei, dass die korrekte Ermittlung von Grundschwingungs-Komponenten nicht möglich Ist. Das hat zur Folge, dass die Fehlerortung relativ ungenau ist.

Eine Verbesserung des Ergebnisses kann durch Verwendung einer zweiseitigen Fehlerortungsmethode erreicht werden. Hierfür ist jedoch die Installation von Messgeräten an beiden Leitungsenden erforderlich, wobei die Messgeräte miteinander kommunizieren können müssen. In vielen Netzen, die geographisch ungünstig liegen, ist diese Kommunikation nicht immer gewährleistet

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden. Bei dem bekannten Verfahren findet eine Fehlerortung durch Messung an beiden Leitungsenden statt. Hierfür muss eine hochgenaue zeitliche Synchronisation zwischen den Messgeräten an den beiden Leitungsenden vorliegen, damit einheitliche Zeitstempel vergeben werden können. Zur Bereitstellung eines an beiden Enden synchronen Zeitsignals sind hierbei beispielsweise Empfänger eines satellitengestützten Zeitimpulses (z.B. eines GPS-Signals) notwendig.

Ausgehend von einem Verfahren und einer Einrichtung der eingangs angegebenen Art liegt der Erfindung die Aufgabe zugrunde, eine Fehlerortung vergleichsweise einfach und dennoch mit hoher Genauigkeit in nicht geerdeten Netzen durchführen zu können.

Diese Aufgabe wird durch ein Verfahren nach Patentanspruch 1 gelöst. Erfindungsgemäß ist hierbei vorgesehen, dass die gemessenen Strom- und Spannungswerte unter Verwendung einer Clarke-Transformation in $\alpha$-Komponenten und 0-Komponenten der Clarke-Transformation umgesetzt werden, unter Verwendung der in die $\alpha$-Komponente umgesetzten Strom- und Spannungswerte und eines Ausbreitungsmodells für Wanderwellen auf der Leitung eine ortsabhängige Verlaufsfunktion von $\alpha$-Komponenten-Fehlerspannungswerten bestimmt wird, unter Verwendung der in die 0-Komponente umgesetzten Strom- und Spannungswerte und des Ausbreitungsmodells für Wanderwellen auf der Leitung eine ortsabhängige Verlaufsfunktion von 0-Komponenten Fehlerspannungswerten bestimmt wird, die Übereinstimmung der beiden Verlaufsfunktionen für unterschiedliche gewählte Orte auf der Leitung ermittelt wird, und derjenige gewählte Ort als Fehlerort des Erdschlusses auf der Leitung bestimmt wird, bei dem die beiden Verlaufsfunktionen die stärkste Übereinstimmung aufweisen.

Das erfindungsgemäße Verfahren kommt vorteilhaft mit Messwerten von nur einem Leitungsende aus, wodurch eine aufwendige Kommunikation und Zeitsynchronisation zwischen Messgeräten an beiden Leitungsenden entfällt. Hierfür macht sich die Erfindung die Erkenntnis zunutze, dass sich die Signale der $\alpha$-Komponente und diejenigen der 0-Komponente mit einer unterschiedlichen Ausbreitungsgeschwindigkeit entlang der Leitung ausbreiten und damit einen unterschiedlichen Propagationskoeffizienten aufweisen. Aufgrund der Verschiedenheit der Ausbreitungsgeschwindigkeit der Signale der beiden Komponenten kann an einem Leitungsende der Fehlerort bestimmt werden, da es nur einen einzigen Ort gibt, an dem die Verlaufsfunktionen beider Fehlerspannungswerte übereinstimmen. Der Ort, für den die Übereinstimmung der beiden Verlaufsfunktionen der Fehlerspannungswerte am besten übereinstimmen, wird als Fehlerort des Erdschlusses angesehen.

In dieser Anmeldung werden die Ausdrücke "Fehlerort" und "Entfernung x (bzw. 1-x) des Fehlerortes von einem Leitungsende" teilweise synonym verwendet und sind entsprechend zu verstehen.

Gemäß einer vorteilhaften Ausführungsform des erfindungsgemäßen Verfahrens ist vorgesehen, dass die stärkste Übereinstimmung der beiden Verlaufsfunktionen durch Optimierung einer Zielfunktion ermittelt wird, wobei als Optimierungsgröße für die Zielfunktion der gewählte Ort auf der Leitung verwendet wird.

Hierdurch kann mit vertretbarem Rechenaufwand durch mathematische Optimierung (z.B. eine Minimierung der Zielfunktion) der tatsächliche Fehlerort ermittelt werden.

Konkret kann beispielsweise vorgesehen sein, dass mit der Zielfunktion derjenige Ort als Fehlerort bestimmt wird, für den ein Minimum der Differenz der beiden Verlaufsfunktionen vorliegt.

Dabei kann die Zielfunktion beispielsweise die einfache oder die quadratische Differenz der beiden Verlaufsfunktionen darstellen. Eine Minimierung führt mit rechnerisch verhältnismäßig einfachen Mitteln zum globalen Minimum der Zielfunktion, die den tatsächlichen Fehlerort angibt.

In diesem Zusammenhang kann gemäß einer vorteilhaften Ausführungsform vorgesehen sein, dass bei der Bildung der Zielfunktion frequenzabhängige Amplituden- und/oder Phasenwinkelfehler von zur Erfassung der Strom- und Spannungswerte verwendeten Messwandlern berücksichtigt werden.

Hierdurch kann besonders vorteilhaft das jeweilige Übertragungsverhalten der zur Messung der Strom- und Spannungswerte verwendeten Wandler berücksichtigt werden, so dass bei der Bildung der Zielfunktion frequenzabhängige Übertragungsfehler herausgerechnet werden können. Frequenzabhängige Amplituden- und Phasenwinkelfehler sind üblicherweise den technischen Datenblättern der jeweiligen Messwandler zu entnehmen und damit bekannt.

Konkret kann zudem vorgesehen sein, dass zur Optimierung ein iteratives Optimierungsverfahren, beispielsweise ein Simplex-Downhill-Verfahren, verwendet wird.

Iterative Optimierungsverfahren eignen sich besonders gut zur Ermittlung globaler Minima von Zielfunktionen. Das Simplex-Downhill-Verfahren weist zudem gute Konvergenzeigenschaften auf und kommt ohne aufwendige Ableitungen der Zielfunktionen aus.

Gemäß einer weiteren vorteilhaften Ausführungsform des erfindungsgemäßen Verfahrens ist vorgesehen, dass die gemessenen Strom- und Spannungswerte unter Verwendung der Clarke-Transformation auch in $\beta$-Komponenten der Clarke-Transformation mit jeweils einer Phase als Bezugsphase umgesetzt werden, die $\beta$-Komponenten der Strom- und/oder Spannungsmesswerte der einzelnen Phasen miteinander verglichen werden, und diejenige Phase als von dem Erdschluss betroffen ermittelt wird, für die die $\beta$-Komponenten der vor dem Fehlereintritt gemessenen Strom- und/oder Spannungsmesswerte im Vergleich zu den $\beta$-Komponenten der nach dem Fehlereintritt gemessenen Strom- und/oder Spannungsmesswerte die geringste Änderung aufweisen.

Auf diese Weise kann mit vergleichsweise niedrigem Aufwand auch eine Erkennung der vom Erdschluss betroffenen Phase durchgeführt werden. Die Phase, für die das Änderungsminimum mittels der $\beta$-Komponente ermittelt wurde, wird dann als Bezugsphase zur Ermittlung der $\alpha$- und der 0-Komponente verwendet. Diese Ausführungsform der Erfindung beruht auf der Erkenntnis, dass sich die Fehlerkomponenten des Erdschlusses im Wesentlichen in der $\alpha$- und der 0-Komponente der Clarke-Transformation wiederspiegeln, während die $\beta$-Komponente lediglich vom Laststrom beeinflusst wird. Dieses Verhalten ergibt sich direkt aus dem Wesen der Clarke-Transformation. Nimmt man beispielsweise Phase A als Referenzphase an und es entsteht ein Erdschluss in dieser Phase A, so erkennt man nach Transformation in die Clarke-Komponenten in der $\beta$-Komponente der Phase A keinen Beitrag des Erdschlusses, so dass hinsichtlich einer Betrachtung der $\beta$-Komponente vor und nach dem Fehlereintritt keine (oder nahezu keine) Änderung auftritt. Die $\beta$-Komponente lässt sich damit zur Referenzphasenbestimmung verwenden. Basierend auf dieser Auswertung lässt sich als Referenzphase immer die fehlerbehaftete Phase bestimmen, so dass die eigentliche Fehlerortung auf der Basis der einzig vorhandenen $\alpha$- und der 0-Komponenten stattfinden kann.

In diesem Zusammenhang kann konkret vorgesehen sein, dass der Fehlerort ausschließlich für die von dem Erdschluss betroffene Phase bestimmt wird.

Auf diese Weise kann der Rechenaufwand zur Ermittlung des Fehlerortes nämlich auf die tatsächlich vom Fehler betroffene Phase beschränkt werden, wodurch die Effizienz des gesamten Verfahrens steigt.

Gemäß einer weiteren vorteilhaften Ausführungsform des erfindungsgemäßen Verfahrens kann zudem vorgesehen sein, dass die in die $\alpha$-Komponente und die in die 0-Komponente der Clarke-Transformation umgesetzten Strom- und Spannungsmesswerte einer Transformation in den Frequenzbereich unterzogen werden, und die Bestimmung des Fehlerortes innerhalb eines ausgewählten Frequenzbereichs durchgeführt wird, der oberhalb der Netzfrequenz des Energieversorgungsnetzes liegt.

Auf diese Weise kann die Fehlerortbestimmung sehr genau mit denjenigen transienten Anteilen der Strom- und Spannungssignale durchgeführt werden, die sich am ehesten für die Ermittlung des Fehlerortes eignen. Die Umsetzung der Strom- und Spannungswerte in den Frequenzbereich kann beispielsweise mittels einer numerischen Fouriertransformation (Fast Fourier Transformation - FFT, Discrete Fourier Transformation - DFT) stattfinden.

Konkret kann hierbei vorgesehen sein, dass der ausgewählte Frequenzbereich bandbegrenzte transiente Anteile der $\alpha$- und der 0-Komponente der gemessenen Strom- und Spannungswerte, vorzugsweise einen Frequenzbereich von 600 Hz bis 15 kHz, umfasst.

Die ausgewählte Frequenz sollte derart bestimmt sein, dass einerseits die Wandler zur Erfassung der Strom- und Spannungswerte ein gutes Übertragungsverhalten aufweisen und andererseits der Energiegehalt der Strom- und Spannungswerte ausreichend hoch ist, um die Analyse zuverlässig auszuführen. Eine weitere vorteilhafte Ausführungsform des erfindungsgemäßen Verfahrens sieht vor, dass die gemessenen Strom- und Spannungswerte vor der Durchführung der Clarke-Transformation einer Filterung unterzogen werden, wobei als Filter ein Tiefpassfilter verwendet wird.

Hierdurch kann erreicht werden, dass das zu transformierende Signal bereits bandbreitenbegrenzt ist und zu hohe Frequenzanteile in Bereichen, in denen die Wandler eine schlechte Übertagungscharakteristik aufweisen, von vornherein ausgeblendet werden.

Gemäß einer weiteren vorteilhaften Ausführungsform des erfindungsgemäßen Verfahrens ist vorgesehen, dass die Leitung kontinuierlich auf das Auftreten eines Erdschlusses überwacht wird, und die Bestimmung des Fehlerortes ausschließlich dann durchgeführt wird, wenn ein Erdschluss bezüglich der Leitung erkannt worden ist.

Auf diese Weise wird das Fehlerortungsverfahren quasi zweischrittig durchgeführt. In einem ersten Schritt wird zunächst das bloße Vorhandensein eines Erdschlusses festgestellt. Erst wenn ein solcher erkannt worden ist, wird in einem zweiten Schritt die Fehlerortung gestartet. Damit kann der Rechenaufwand insgesamt gering gehalten werden, da die Fehlerortung nur nach Bedarf angestoßen wird.

In diesem Zusammenhang kann konkret vorgesehen sein, dass das Vorliegen eines Erdschlusses dann erkannt wird, wenn im Verlauf der Strom- und Spannungswerte oder davon abgeleiteten Werten ein Sprung festgestellt worden ist, der eine vorgegebene Schwelle übersteigt, oder wenn ein für einen Erdschluss charakteristisches Verhalten eines Summennullstroms und einer Verlagerungsspannung vorliegt.

Sprungerkennungen und das sogenannte wattmetrische Verfahren, bei dem eine Auswertung des Summennullstroms und der Verlagerungsspannung stattfindet, sind übliche Erdschlusserkennungsverfahren für isolierte oder gelöschte Netze, die dem Fachmann hinreichend bekannt sind. In diesem Rahmen findet auch eine Richtungserkennung statt, um den fehlerbehafteten Leitungsabschnitt eindeutig zu identifizieren. Die Fehlerortung kann dann ausschließlich für den fehlerbehafteten Abschnitt durchgeführt werden. Zur Richtungsbestimmung kann ein an sich bekanntes Verfahren auf Basis der Blind- (nicht geerdeter Sternpunkt) oder Wirkleistung (kompensierter Sternpunkt) eingesetzt werden oder es wird die Leistungsrichtung aus Ergebnissen einer Fouriertransformation durch Multiplikation der Spannungszeiger mit den konjugiert komplexen Stromzeigern gebildet. Eine Fehlerortung ist dann sinnvoll, wenn eine vorwärtsgerichtete Fehlerrichtung erkannt worden ist.

Gemäß einer weiteren vorteilhaften Ausführungsform des erfindungsgemäßen Verfahrens kann schließlich vorgesehen sein, dass bei einer Leitung in Form eines aus mehreren Segmenten zusammengesetzten Kabels diejenige Verbindungstelle zwischen zwei Segmenten des Kabels als tatsächlicher Fehlerort eines selbstlöschenden Erdfehlers bestimmt wird, die dem bei der Optimierung der Zielfunktion bestimmten Fehlerort am nächsten liegt.

Auf diese Weise kann durch Verwendung von zusätzlichem Wissen über die fehlerbehaftete Leitung die Fehlerortung bei einem selbstlöschenden Erdschluss noch genauer ausgeführt werden. Gerade bei Erdkabeln ist es nämlich von besonderem Nutzen, die Stelle, an der das Erdkabel ausgegraben werden muss, möglichst genau eingrenzen zu können, um den baulichen Aufwand möglichst gering zu halten. Da ein selbstlöschender Erdschluss bei Erdkabeln prinzipiell nur an der Verbindungsstelle (Muffe) zweier Kabelsegmente auftreten kann, kann bei Kenntnis der Lage der Muffen entlang der Kabelstrecke der genaue Fehlerort entsprechend gut eingegrenzt werden.

Die oben genannte Aufgabe wird auch durch eine Einrichtung zum Ermitteln des Fehlerortes eines Erdschlusses bezüglich einer Leitung eines dreiphasigen elektrischen Energieversorgungsnetzes mit nicht geerdetem Sternpunkt, mit einer Recheneinrichtung, die dazu eingerichtet ist, unter Verwendung von an einem Leitungsende der Leitung gemessenen ersten Strom- und Spannungswerten nach dem Auftreten eines Fehlers auf der Leitung dessen Fehlerort zu bestimmen, gelöst.

Erfindungsgemäß ist vorgesehen, dass die Recheneinrichtung dazu eingerichtet ist, die gemessenen Strom- und Spannungswerte unter Verwendung einer Clarke-Transformation in $\alpha$-Komponenten und 0-Komponenten der Clarke-Transformation umzusetzen, die Recheneinrichtung dazu eingerichtet ist, unter Verwendung der in die $\alpha$-Komponente umgesetzten Strom- und Spannungswerte und eines Ausbreitungsmodells für Wanderwellen auf der Leitung eine ortsabhängige Verlaufsfunktion von $\alpha$-Komponenten-Fehlerspannungswerten zu bestimmen, die Recheneinrichtung dazu eingerichtet ist, unter Verwendung der in die 0-Komponente umgesetzten Strom- und Spannungswerte und des Ausbreitungsmodells für Wanderwellen auf der Leitung eine ortsabhängige Verlaufsfunktion von 0-Komponenten-Fehlerspannungswerten zu bestimmen, die Recheneinrichtung dazu eingerichtet ist, die Übereinstimmung der beiden Verlaufsfunktionen für unterschiedliche gewählte Orte auf der Leitung zu ermitteln, und die Recheneinrichtung dazu eingerichtet ist, denjenigen gewählten Ort als tatsächlichen Fehlerort des Erdschlusses auf der Leitung zu bestimmen, bei dem die beiden Verlaufsfunktionen die stärkste Übereinstimmung aufweisen.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann gemäß einer vorteilhaften Ausführungsform der erfindungsgemäßen Einrichtung vorgesehen sein, dass die Einrichtung ein elektrisches Schutzgerät ist. Hierbei kann die Einrichtung vorteilhaft durch ein elektrisches Schutzgerät gebildet sein, das neben der Fehlerortung noch weitere Schutz- und Überwachungsfunktionen für das elektrische Energieversorgungsnetz (z.B. eine Distanzschutzfunktion, eine Überstromschutzfunktion oder eine Differentialschutzfunktion für die Leitung) durchführt. Alternativ dazu kann jedoch auch vorgesehen sein, dass die Einrichtung eine separate Fehlerlokalisier-Einrichtung ist.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1 eine schematische Ansicht einer Leitung eines Energieversorgungsnetzes mit einer Einrichtung zur Ermittlung eines Fehlerortes;

Figur 2 eine Darstellung der elektrischen Parameter eines Leitungsabschnitts $\Delta x$ zur Erläuterung der Bestimmung eines Fehlerortes nach dem Wanderwellenprinzip;

Figur 3 beispielhafte Verläufe von Strom- und Spannungsmesswerten;

Figur 4 ein Ersatzschaltbild eines Erdschlusses im Raum von modalen Clarke-Komponenten;

Figur 5 beispielhafte Verläufe von Clarketransformierten Strom- und Spannungsmesswerten;

Figur 6 ein beispielhaftes Frequenzspektrum einer $\alpha$-Komponente der Clarke-Transformation während eines Erdschlusses;

Figur 7 ein beispielhaftes Frequenzspektrum einer 0-Komponente der Clarke-Transformation während eines Erdschlusses;

Figur 8 beispielhafte Verlaufsfunktionen der Fehlerspannungen von 0- und $\alpha$-Komponente für einen gewählten Ort, der dem tatsächlichen Fehlerort entspricht;

Figur 9 beispielhafte Verlaufsfunktionen der Fehlerspannungen von 0- und $\alpha$-Komponente für einen gewählten Ort, der dem tatsächlichen Fehlerort nicht entspricht;

Figur 10 ein beispielhafter Verlauf einer Zielfunktion zur Fehlerortung;

Figur 11 ein beispielhafter Verlauf des Konvergenzverhaltens einer iterativen Methode zur Lösung der Zielfunktion; und

Figur 12 eine schematische Ansicht eines Ablaufdiagramms zur Erläuterung eines Ausführungsbeispiels eines Verfahrens zur Fehlerortung.

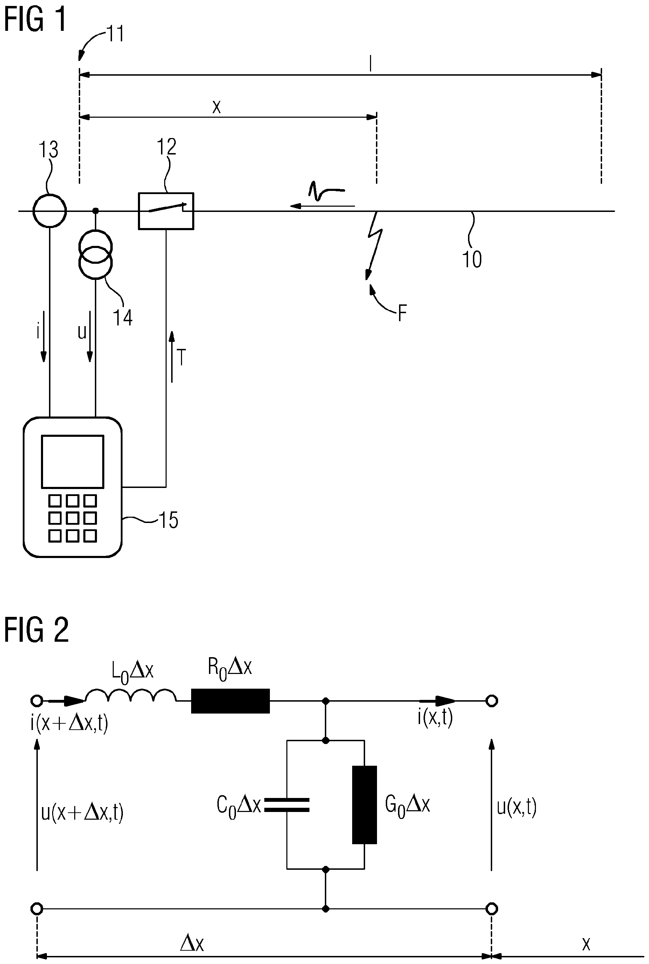

Figur 1 zeigt eine elektrische Leitung 10 eines ansonsten nicht dargestellten Energieversorgungsnetzes in vereinfachter einphasiger Darstellung. Bei dem Energieversorgungsnetz handelt es sich tatsächlich um ein dreiphasiges Energieversorgungsnetz, das einen nicht wirksam geerdeten Sternpunkt aufweist, d.h. mit isoliertem oder kompensiertem Sternpunkt betrieben wird. Die Leitung 10 habe die Länge 1.

Die Leitung 10 wird an ihrem einen Leitungsende 11 durch einen Leistungsschalter 12 begrenzt und kann durch diesen vom restlichen Energieversorgungsnetz abgetrennt werden. Am Leitungsende 11 ist zudem eine Messstelle vorgesehen, an der mit in Figur 1 lediglich beispielhaft dargestellten Stromwandlern 13 und Spannungswandlern 14 Strom- und Spannungsmesswerte erfasst werden. Bei den Stromwandlern 13 und den Spannungswandlern 14 kann es sich um sogenannte konventionelle oder um nicht konventionelle Wandler handeln. Sekundärseitig werden von den Wandlern Strommesswerte i und Spannungsmesswerte u abgegeben, bei denen es sich um analoge oder digitalisierte Werte handeln kann.

Mit den Stromwandlern 13 und den Spannungswandlern 14 steht am Leitungsende 11 eine Einrichtung 15 zur Ermittlung eines Fehlerortes in Verbindung. Bei dieser Einrichtungen 15 kann es sich beispielsweise um ein elektrisches Schutzgerät handeln, das neben einer Fehlerortungsfunktion auch weitere Schutz- und Überwachungsfunktionen durchführen kann. Ein solches Schutzgerät überwacht den Betriebszustand der Leitung 10 anhand der erfassten Strom- und Spannungsmesswerte und übermittelt im Fehlerfall ein Ausschaltsignal T an den Leistungsschalter 12, um diesen zum Öffnen seiner Schaltkontakte zu veranlassen.

Falls es sich bei dem Fehler um einen einfachen Erdschluss handelt, ist in einem Energieversorgungsnetz mit isoliertem oder kompensiertem Sternpunkt eine Abschaltung der Leitung noch nicht notwendig, da der fließende Fehlerstrom aufgrund der fehlenden Erdung sehr gering ist. Dennoch ist die Ermittlung des Fehlerortes notwendig, um eine Ausweitung des Fehlers zu vermeiden. Die Einrichtung 15 ist daher dazu eingerichtet, im Fall eines Erdschlusses auf der Leitung 10 den Fehlerort, also denjenigen Ort auf der Leitung, an dem der Erdschluss aufgetreten ist, zu ermitteln und auszugeben. Hierzu verwendet es die Strom- und Spannungsmesswerte, die während des Fehlers erfasst worden sind.

Die Einrichtung 15 führt eine Fehlerortung nach dem sogenannten Wanderwellenprinzip aus. Dabei wird ausgenutzt, dass beim Auftreten eines Fehlers hochfrequente transiente Signalanteile im Strom und in der Spannung entstehen, die sich etwa mit Lichtgeschwindigkeit auf einer Freileitung 10 ausbreiten (in Leitungen in Form von Kabeln ist die Ausbreitungsgeschwindigkeit geringer, etwa halb so groß). Dies ist in Figur 1 beispielhaft eingezeichnet. Hierzu wird angenommen, dass an einem Fehlerort F ein Fehler aufgetreten sei. Die Wanderwellen breiten sich wie dargestellt von dem Fehlerort F aus und können am Leitungsende mit den Wandlern 13, 14 messtechnisch erfasst und mit der Einrichtung 15 zur Fehlerortbestimmung ausgewertet werden. Von dem Leitungsende aus gesehen liegt der Fehlerort F in einer Entfernung x. Die Einrichtung wertet wie nachfolgend im Einzelnen beschrieben die Strom- und Spannungsmesswerte aus und gibt den Fehlerort F, beispielsweise als Entfernung x oder in Prozent der Leitungslänge 1 aus.

Der Betreiber des Energieversorgungsnetzes kann den ermittelten Fehlerort F an ein Wartungsteam weitergeben, das daraufhin den Fehlerort aufsuchen und die Fehlerursache beheben kann. Hierzu ist eine möglichst genaue Ermittlung des Fehlerortes erforderlich. Nachfolgend wird eine Vorgehensweise zur Fehlerortung beschrieben, die allein mit den Messwerten an einem Leitungsende auskommt.

Zunächst soll eine kurze Erläuterung des Prinzips der Wanderwellen-Fehlerortung gegeben werden. Dabei wird ein Ausbreitungsmodell für Wanderwellen entlang der Leitung 10 verwendet.

Zur Aufstellung des fraglichen Algorithmus wird die "Theorie der Langen Leitungen" eingesetzt. Es handelt sich hierbei um die modellhafte Abbildung einer elektrischen Leitung in Form von sogenannten "verteilten Parametern". Dies ist beispielhaft in Figur 2 dargestellt.

Der Figur 2 ist zu entnehmen, dass die Netzparameter wie Induktivitätsbelag $L_0$, Kapazitätsbelag $C_0$, Widerstandsbelag $R_0$ sowie Konduktivitätsbelag $G_0$ längs der Leitung verteilt sind. Basierend auf diesem Leitungsmodell können unter Verwendung der Kirchhoffschen-Gesetze für das Teilstück $\Delta x$ der Leitung folgende Gleichungen für die Spannung u und den Strom i aufgestellt werden:

$$u(x + \Delta x, t) = R_0 \Delta x \cdot i(x + \Delta x, t) + L_0 \Delta x \frac{\partial i(x + \Delta x, t)}{\partial t} + u(x, t) \qquad (1)$$

$$i(x + \Delta x, t) = G_0 \Delta x \cdot u(x, t) + C_0 \Delta x \frac{\partial u(x, t)}{\partial t} + i(x, t) \qquad (2)$$

Durch mathematische Umformungen lassen sich die Gleichungen (1) und (2) in die folgende Form überführen:

$$\frac{\partial u(x, t)}{\partial x} = R_0 \cdot i(x, t) + L_0 \frac{\partial i(x, t)}{\partial t} \qquad (3)$$

$$\frac{\partial i(x,t)}{\partial x} = G_0 \cdot u(x,t) + C_0 \frac{\partial u(x,t)}{\partial t} \qquad (4)$$

Diese Gleichungen (3) und (4) sind partielle Differentialgleichungen einer homogenen Leitung und werden üblicherweise als "Telegraphengleichungen" bezeichnet. Sie lassen sich auf beliebige Leiter verallgemeinern.

Durch die Betrachtung der Gleichungen (3) und (4) im Laplace-Bereich unter der Annahme von x als Parameter lassen sich viele in der Leitung entstehende Effekte wesentlich einfacher interpretieren:

$$\frac{\partial u(x,s)}{\partial x} = R_0 \cdot i(x,s) + sL_0 \cdot i(x,s) \qquad (5)$$

$$\frac{\partial i(x,s)}{\partial x} = G_0 \cdot u(x,s) + sC_0 \cdot u(x,s) \qquad (6)$$

Die Ableitung der Gleichungen (5) und (6) nach Parameter x ergibt:

$$\frac{\partial^2 u(x,s)}{\partial x^2} = Z(s)Y(s) \cdot u(x,s) \qquad (7)$$

$$\frac{\partial^2 i(x,s)}{\partial x^2} = Y(s)Z(s) \cdot i(x,s) \qquad (8)$$

Gleichungen (7) und (8) lassen sich unter Verwendung der Differentialgleichungstheorie für Spannung und Strom separat lösen:

$$U(x) = e^{-\gamma(s)x} \cdot A_1 + e^{\gamma(s)x} \cdot A_2 \qquad (9)$$

$$Z_c(s) \cdot I(x) = e^{-\gamma(s)x} \cdot A_1 - e^{\gamma(s)x} \cdot A_2 \qquad (10)$$

Bei der Lösung der Gleichungen (9) und (10) ist es möglich, die unbekannten Parameter $A_1$ und $A_2$ von den Anfangsbedingungen auszurechnen:

$$A_1 = \frac{1}{2}\left(U_1(s) + Z_c(s) \cdot I_1(s)\right) \qquad (11)$$

$$A_2 = \frac{1}{2}\left(U_1(s) - Z_c(s) \cdot I_1(s)\right) \qquad (12)$$

wobei $U_1$ und $I_1$ die Anfangsbedingungen bei x=0 darstellen. Darüber hinaus beinhalten Gleichungen (9) und (10) eine sogenannte Wellenimpedanz $Z_C$ und die Ausbreitungskonstante y, die sich aus den Leitungsparametern berechnen lassen:

$$\gamma(s)^2 = Z(s)Y(s) \qquad (13)$$

$$Z_c(s) = \gamma(s)^{-1} \cdot Z(s) \qquad (14)$$

Hierbei steht Z für die Längsimpedanz und Y für die Queradmittanz eines Abschnitts der Leitung. Die Werte werden jeweils längenbezogen angegeben.

Somit ergeben sich für die Gleichungen (9) und (10) folgende Formen:

$$U(x,s) = \frac{1}{2}e^{-\gamma(s)x} \cdot \left(U_1(s) + Z_c(s) \cdot I_1(s)\right) + \frac{1}{2}e^{\gamma(s)x} \cdot \left(U_1(s) - Z_c(s) \cdot I_1(s)\right) \tag{15}$$

$$Z_c(s) \cdot I(x,s) = \frac{1}{2}e^{-\gamma(s)x} \cdot \left(U_1(s) + Z_c(s) \cdot I_1(s)\right) - \frac{1}{2}e^{\gamma(s)x} \cdot \left(U_1(s) - Z_c(s) \cdot I_1(s)\right) \tag{16}$$

Gleichungen (15) und (16) stellen ein spannungs- bzw. strombezogenes Ausbreitungsmodell für Wanderwellen entlang der Leitung 10 dar. Für die nachfolgend beschriebene Wanderwellen-Fehlerortung wird die Fehlerspannung an dem zunächst unbekannten Fehlerort F betrachtet. Dabei wird auf den in Gleichung (15) beschriebenen Zusammenhang zurückgegriffen.

Diese Spannungsgleichung (15) lässt sich in folgender Form im Laplace-Bereich darstellen:

$$U(x,s) = U_1(s)\cosh\gamma(s)x - Z_c(s) \cdot I_1(s)\sinh\gamma(s)x \tag{17}$$

Der Übergang zum Frequenzbereich erfolgt durch Einsetzen von s=jω, wobei für die Kreisfrequenz steht:

$$U(x,j\omega) = U_1(j\omega)\cosh\gamma(j\omega)x - Z_c(j\omega) \cdot I_1(j\omega)\sinh\gamma(j\omega)x \tag{18}$$

Es entsteht die analytische Gleichung (18), die für jede auftretende Frequenz f= ω/2π erfüllt ist. Aus diesem Grund kann man die Betrachtung auf ein gewähltes Frequenzspektrum begrenzen.

Bei dem nachfolgend beschriebenen Verfahren zur Fehlerortung werden Transienten im Bereich von wenigen Hundert Hertz bis wenigen Kilohertz verwendet. Der Frequenzbereich wird nach folgenden Kriterien selektiert:

- Das selektierte Frequenzband muss im Übertragungsbereich der Primärwandler 13, 14 liegen;

- Das selektierte Frequenzband muss einen Bereich abdecken, in dem die bei einem Erdschluss entstehenden Transienten einen möglichst hohen Energiegehalt aufweisen.

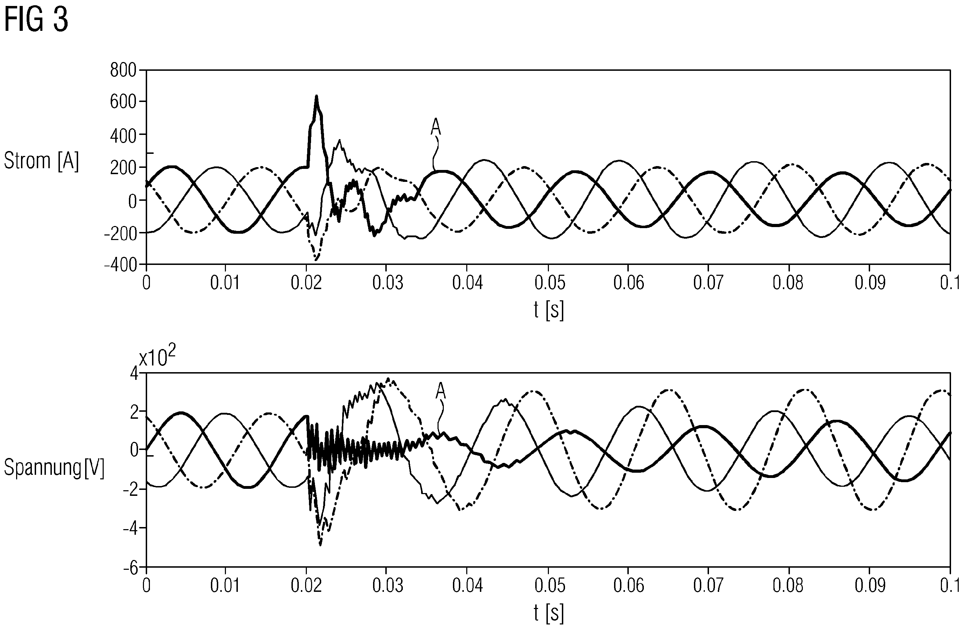

In Figur 3 sind Verläufe von Strom- und Spannungswerten im Zeitbereich bei einem einphasigen Erdschluss in Phase A gezeigt. Der in Figur 3 dargestellte Erdschluss verursacht nur unwesentliche Änderungen in den Strömen bei Nennfrequenz. Die Spannung in den Phasen B und C steigt jeweils um den Faktor $\sqrt{3}$. In den Strom- und Spannungssignalen können Transienten beobachtet werden, die im vorgeschlagenen Verfahren zur Fehlerortung genutzt werden.

In der Figur 3 sind in diesem Zusammenhang deutlich die durch den Fehlereintritt hervorgerufenen Frequenzanteile oberhalb der Nennfrequenz zu erkennen. Führt man eine Frequenzanalyse durch, ergibt sich, dass die Spektralanteile mit dem größten Energieinhalt im Bereich bis zu einigen Kilohertz (typisch z.B. bis zu 15 kHz) liegen. Der Energiegehalt der Transienten nimmt in Richtung höherer Frequenzen kontinuierlich ab. Typische Mittelspannungs-Stromwandler übertragen einen Frequenzbereich bis ca. 10-20kHz. Der nach diesen Kriterien selektierte Frequenzbereich wird mittels eines Filters bandbegrenzt (Durchlassbereich eines Tiefpassfilters z.B. 0kHz bis 15kHz). Durch Verwendung des Tiefpassfilters können die Transienten mit einem Abtastsystem abgetastet und zur Erdschlussortung benutzt werden. Sie stellen ein Muster dar, das für jede Fehlerposition unterschiedlich und von der Netzbeschaffenheit abhängig ist.

Weiterhin ist leicht nachvollziehbar, dass aus dem Verlauf der Signale eine Erdschlussortung nach konventionellen impedanzbasierten Methoden nur schwer möglich ist. Ein transienter Erdschluss ist zudem nur für eine Dauer von ca. 13ms vorhanden. In diesem Zeitabschnitt sind die Signale so gestört, dass eine Bestimmung der Grundwellenzeiger zu sehr großen Messfehlern führen würde. Außerdem ist bei diesen Signalen zu bemerken, dass auch die nicht fehlerbetroffen Phasen Transienten aufweisen.

Da es sich bei dem Energieversorgungsnetz vorliegend um ein dreiphasiges Netz handelt, ist es notwendig, die oben gegebene Gleichung (18) in einer Matrixform zu präsentieren. Die Vereinfachung solch eines Gleichungssystems kann durch eine modale bzw. Eigenwerttransformation erfolgen. Auf diese Art und Weise wird erreicht, dass die einzelnen Gleichungen des entstehenden Gleichungssystems voneinander entkoppelt werden und somit unabhängig voneinander betrachtet werden können. Darüber hinaus ermöglicht diese Transformation, die bereits aufgestellten Gleichungen in transformierten Komponenten zu betrachten.

Beispielhaft sei nachfolgend eine einfache symmetrische Leitung betrachtet, die folgende Parameter für einen Nennfrequenz von 60Hz besitzt:

$$Z = \begin{bmatrix} 0.187 + j0.858 & 0.098 + j0.3705 & 0.098 + j0.3705 \\ 0.098 + j0.3705 & 0.187 + j0.858 & 0.098 + j0.3705 \\ 0.098 + j0.3705 & 0.098 + j0.3705 & 0.187 + j0.858 \end{bmatrix} \Omega \qquad (19)$$

$$Y = 1e - 5 \begin{bmatrix} j0.3 & -j0.036 & -j0.036 \\ -j0.036 & j0.3 & -j0.036 \\ -j0.036 & -j0.036 & j0.3 \end{bmatrix} S \qquad (20)$$

Hierbei steht Z für die Leitungsimpedanz und Y für die Leitungsadmittanz. Zur Entkopplung wird als modale Transformation die sogenannte "Clark-Transformation" herangezogen. Diese weist eine Transformationsmatrix T wie folgt auf; es entstehen sogenannte $\alpha$-, $\beta$- und 0-Komponenten:

$$T = \frac{2}{3} \begin{bmatrix} 1 & -0.5 & -0.5 \\ 0 & \frac{\sqrt{3}}{2} & -\frac{\sqrt{3}}{2} \\ 0.5 & 0.5 & 0.5 \end{bmatrix} \qquad (21)$$

Mit der Clarke-Transformation lässt sich die oben genannten Matrizen (19) und (20) folgendermaßen transformieren:

$$Z_{\alpha\beta 0} = TZT^{-1} = \begin{bmatrix} 0.0894 + j0.487 & 0 & 0 \\ 0 & 0.0894 + j0.487 & 0 \\ 0 & 0 & 0.383 + j1.599 \end{bmatrix} \Omega \qquad (22)$$

$$Y_{\alpha\beta 0} = TYT^{-1} = 1e^{-5} \begin{bmatrix} j0.336 & 0 & 0 \\ 0 & j0.336 & 0 \\ 0 & 0 & j0.229 \end{bmatrix} S \qquad (23)$$

In Verbindung mit Gleichungen (13) und (14) ergeben sich daraus die drei zu betrachtenden Ausbreitungskonstanten (Gleichung (24)) und Wellenimpedanzen (Gleichung (25)):

$$\gamma_{\alpha\beta 0} = \begin{bmatrix} 0.0001 + j0.00128 & 0 & 0 \\ 0 & 0.0001 + j0.00128 & 0 \\ 0 & 0 & 0.0002 + j0.0019 \end{bmatrix} \qquad (24)$$

$$Z_{C\alpha\beta0} = 1e+2 \begin{bmatrix} 3.821 - j0.3475 & 0 & 0 \\ 0 & 3.821 - j0.3475 & 0 \\ 0 & 0 & 8.411 - j0.994 \end{bmatrix} \Omega \qquad (25)$$

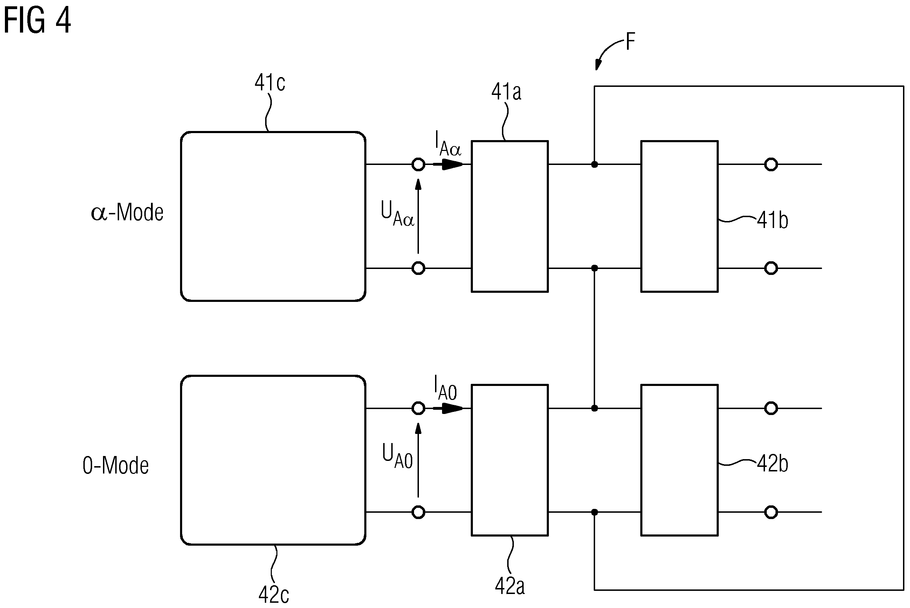

Neben der Entkopplung des Dreiphasensystems wird die Clarke-Transformation vorliegend auch zur eigentlichen Fehlerortung herangezogen. Jede Fehlerart lässt sich nämlich in dem Modalen-Raum mathematisch beschreiben und entsprechend in Form eines Ersatzschaltbildes darstellen. So besteht auch für den Erdschluss in nicht geerdeten Netzen eine Darstellung. Diese ist beispielhaft in Figur 4 für die Phase A des Energieversorgungsnetzes dargestellt. Man erkennt für die α-Komponente ("α-Mode") sowie für die 0-Komponente ("0-Mode") jeweils zwei die Leitung 10 darstellende Blöcke 41a und 41b bzw. 42a und 42b, die a, Fehlerort F miteinander gekoppelt sind. Das restliche Netz ist durch Blöcke 41c bzw. 42c symbolisiert.

Figur 4 ist zu entnehmen, dass der Erdschluss nur Einfluss nur auf α- und die 0-Komponente hat. Die β-Komponente bleibt hingegen ungestört und trägt nur die Information über den Lastfluss. Diese Eigenschaft wird kann zur Identifizierung der fehlerbehafteten Phase genutzt werden, so dass das Fehlerortungsverfahren gezielt für die Fehlerphase angewendet werden kann. Bei jedem Erdschluss kann die Referenzphase so gewählt werden, dass die β-Komponente ungestört ist. Der Figur 4 ist es zu entnehmen, dass an der Erdschlussstelle (Fehlerort F) die Spannungen in der 0- und der α-Komponente gleich sein müssen. Darüber hinaus besitzen die Signale der 0- und der α-Komponente unterschiedliche Ausbreitungsgeschwindigkeiten $\gamma_0$ bzw. $\gamma_\alpha$. Diese beiden Eigenschaften werden zur Erdschlussortung genutzt. An der Messstelle 11 sind die beiden Komponenten unterschiedlich und müssen quasi auf den korrekten Fehlerort normiert werden. Dies wird durch die Verwendung der Telegraphen-Gleichung im Frequenzbereich im Raum von Modalen-Komponenten durchgeführt. Der Verlauf der beiden modalen Spannungen in der 0- und der α-Komponente ist von der Entfernung x abhängig. Damit ergeben sich aus Gleichung (18) für die α- und die 0-Komponente (α-Komponenten-Fehlerspannungswerte gemäß Gleichung (26) und 0-Komponenten-Fehlerspannungswerte gemäß Gleichung (27)):

$$U_\alpha(x, j\omega) = U_{1,\alpha}(j\omega) \cosh \gamma_\alpha(j\omega)x - Z_{c,\alpha}(j\omega) \cdot I_{1,\alpha}(j\omega) \sinh \gamma_\alpha(j\omega)x \qquad (26)$$

$$U_0(x, j\omega) = U_{1,0}(j\omega) \cosh \gamma_0(j\omega)x - Z_{c,0}(j\omega) \cdot I_{1,0}(j\omega) \sinh \gamma_0(j\omega)x \qquad (27)$$

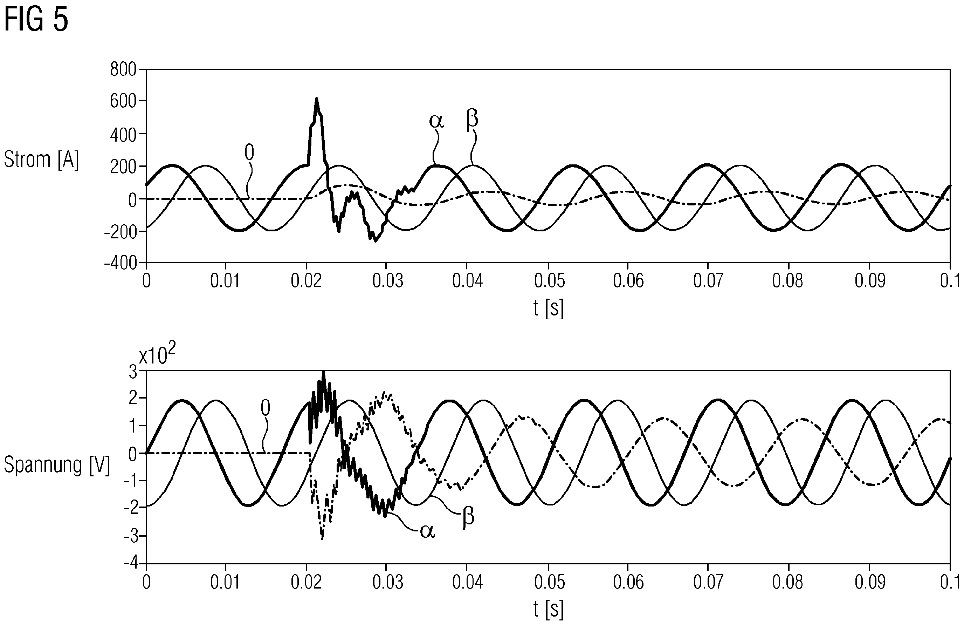

Figur 5 zeigt beispielhaft die Verläufe der α- und der 0-Komponente nach der Clarke- Transformation der Strom- und Spannungswerte aus Figur 3. Die beim Erdschluss auftretenden Reflektionen führen dazu, dass die Transienten entstehen, die dann zur Feststellung des Erdschlussortes benutzt werden. Diese Transienten können in einem kurzen Zeitfenster gemessen werden, dessen Dauer deutlich unter einer Periodendauer der Grundwelle liegt. Hierin liegt ein wesentlicher Vorteil des vorgestellten Fehlerortungsverfahrens. In den meisten Fällen liegt die Erdschlussdauer in Freileitungssystemen nämlich unter einer Periode und kann mit konventionellen Methoden nur schwer erfasst werden.

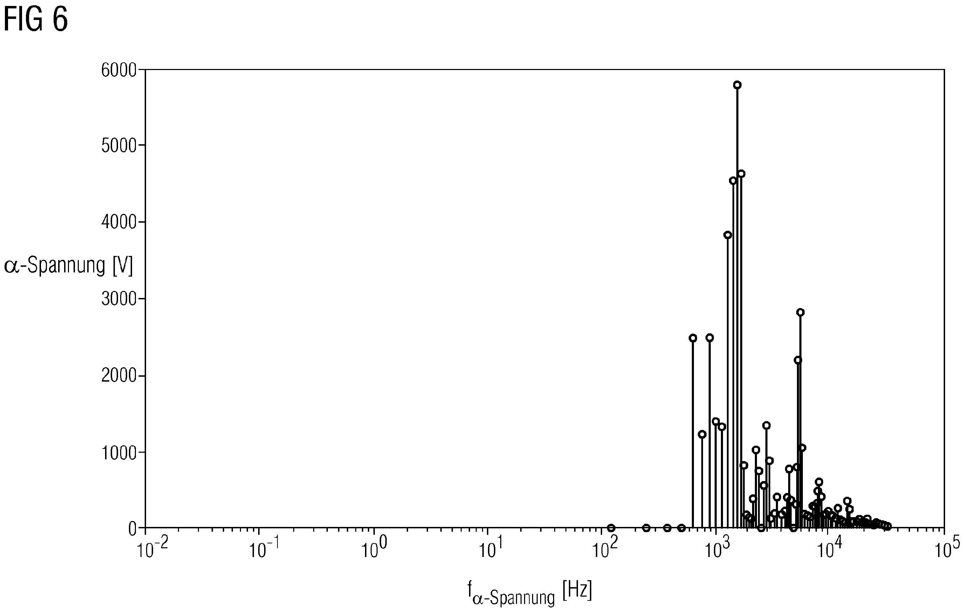

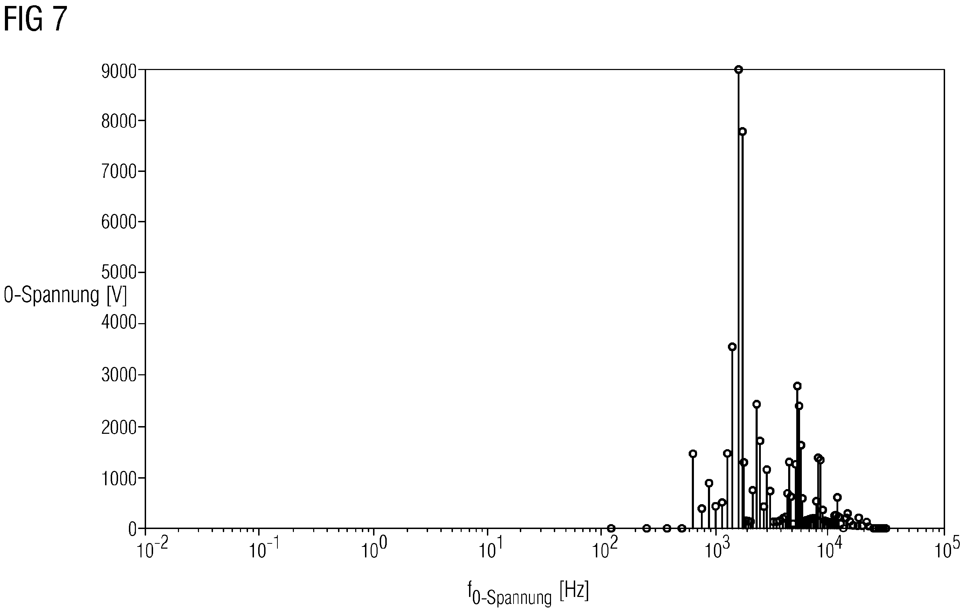

In Abbildungen 6 und 7 sind die Spektren der α- und der 0-Komponente der Spannung während des Erdschlusses bei einer Messfensterdauer von einer halben Periode beispielhaft dargestellt. Entsprechende Analysen lassen sich für die auftretenden Ströme durchführen. Den Figuren 6 und 7 ist zu entnehmen, dass die Transienten mit einer ausreichenden Amplitude (und damit ausreichendem Energiegehalt) in den Signalen vorhanden sind. Diese werden zur Erdschlussortung genutzt. Im vorliegenden Beispiel sieht man besonders deutlich die Resonanz-Frequenzen, die im Bereich von 1,5 kHz liegen. Jeder Erdschluss wird von bestimmten Resonanz-Frequenzen gekennzeichnet, die sich aus Netzausdehnung, Netzparametern sowie dem Erdschlussort ergeben. Da die Resonanz-Frequenzen im Voraus nicht bekannt sind, wird die Fehlerortung in einem Frequenzbereich durchgeführt, der deutlich über der Nennfrequenz des Energieversorgungsnetzes (z.B. 50Hz oder 60Hz) liegt. Im vorliegenden Fall werden z.B. die Frequenzen unter 600Hz nicht berücksichtigt.

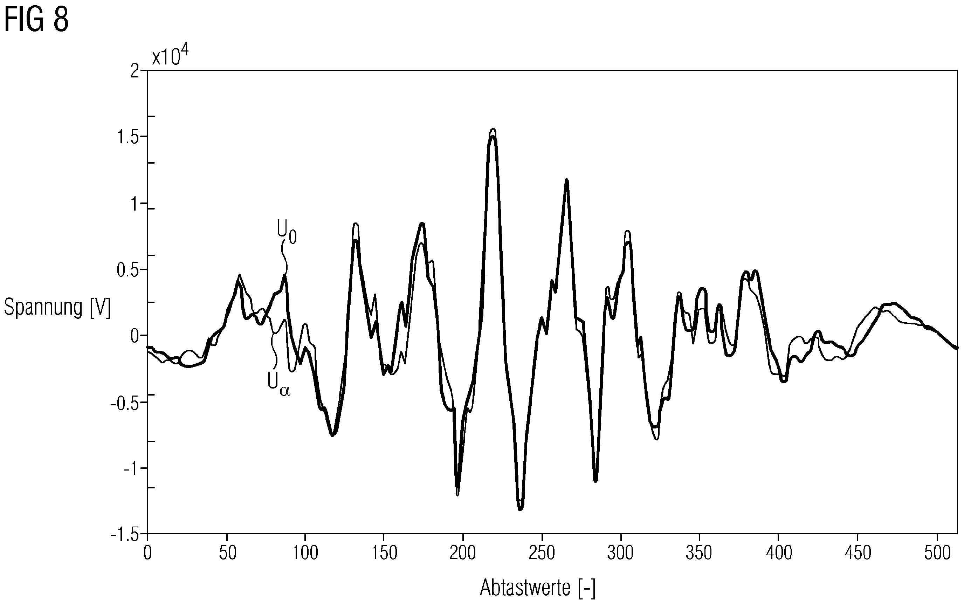

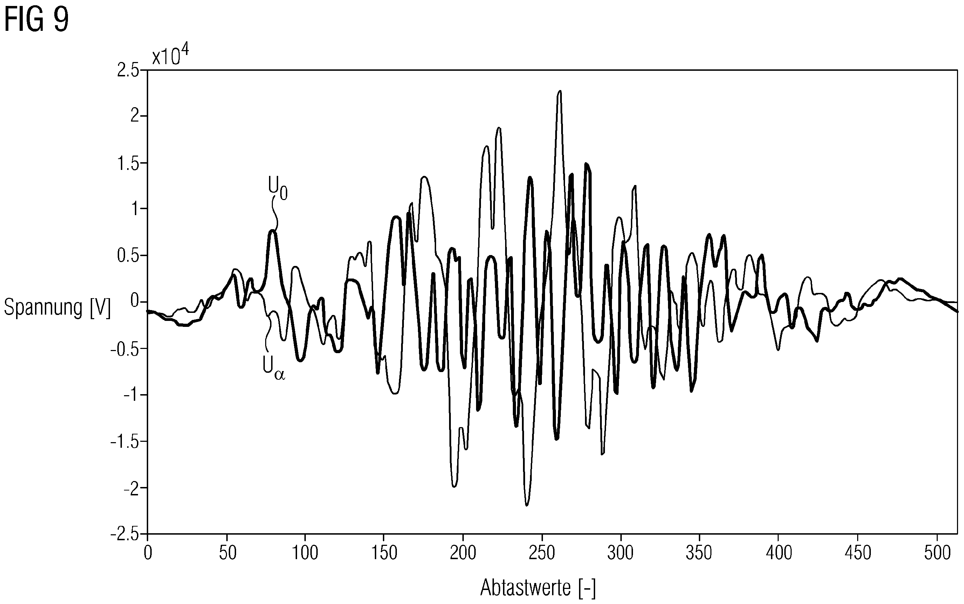

Die Übereinstimmung der beiden modalen Komponenten $U_\alpha$ und $U_0$ gemäß Gleichungen (26) und (27) findet nur an der Fehlerstelle statt. Es gilt daher, denjenigen Ort x zu finden, bei dem die Verlaufsfunktionen (26) und (27) für den gewählten Frequenzbereich übereinstimmen. Beispielhaft sind in Figur 8 die Verlaufsfunktionen der α-Komponenten-Fehlerspannungswerte gemäß Gleichung (26) und der 0-Komponenten-Fehlerspannungswerte gemäß Gleichung (27) für einen Ort x gezeigt, der dem Fehlerort entspricht. In Figur 9 sind hingegen beide Verläufe für einen Ort x gezeigt, der dem Fehlerort nicht entspricht. Man erkennt nur im Fall der Figur 8 (korrekter Fehlerort) eine weitgehende Übereinstimmung der beiden Verlaufsfunktionen.

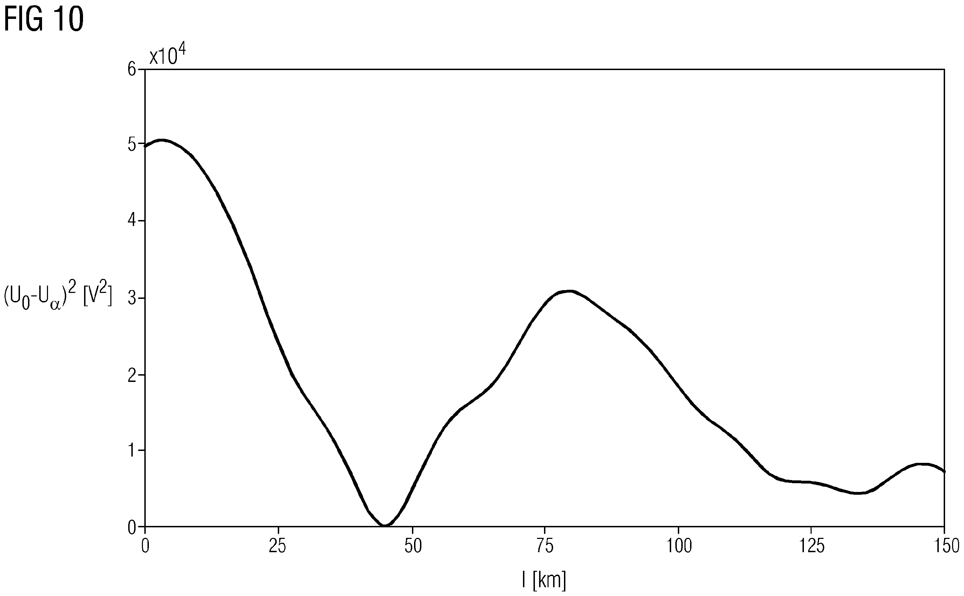

Den Figuren 8 und 9 ist zu entnehmen, dass die Verlaufsfunktionen der α-Komponenten-Fehlerspannungswerte gemäß Gleichung (26) und der 0-Komponenten-Fehlerspannungswerte gemäß Gleichung (27) nur bei dem korrekten Fehlerort eine weitgehende Übereinstimmung aufweisen. Ein vom Fehlerort abweichend gewählter Ort führt dazu, dass die beiden Verlaufsfunktionen nicht übereinstimmen. Daher kann bei einer Auswahl aller möglichen Orte entlang der Gleichung und Vergleich der jeweiligen Übereinstimmung der Verlaufsfunktionen der korrekte Fehlerort ermittelt werden. Zur rechnerischen Durchführung der Suche nach dem korrekten Fehlerort kann eine Zielfunktion erstellt werden, die die Differenz zwischen beiden Spannungen abbildet. Der Verlauf einer solchen Zielfunktion ist für den vorliegenden Fall in Figur 10 dargestellt. Vorliegend ist als ortsabhängige Zielfunktion ZF(x) die quadratische Abweichung der Differenz der Verlaufsfunktionen gewählt:

$$ZF(x) = \left(U_\alpha(x) - U_0(x)\right)^2 \qquad (28)$$

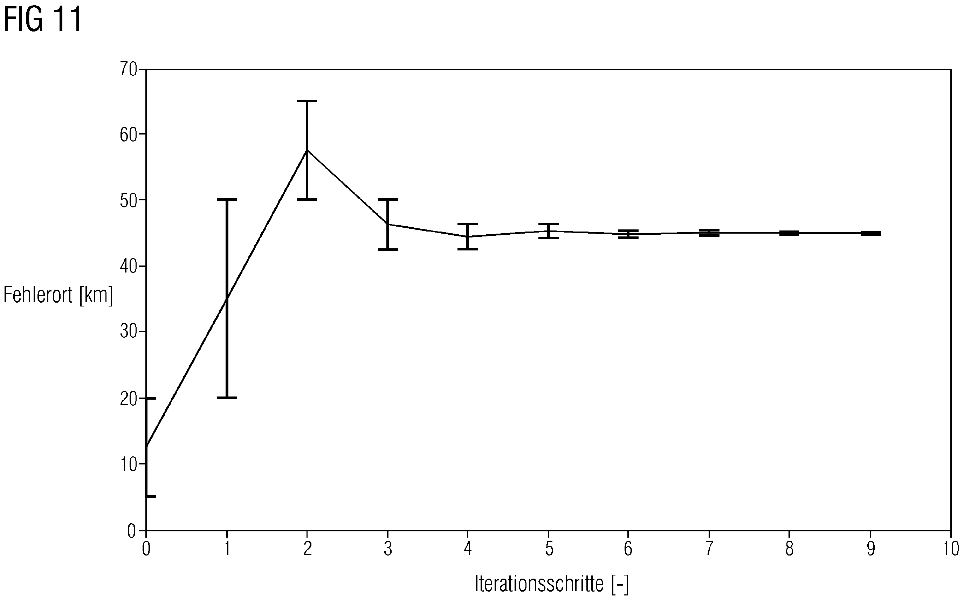

Das globale Minimum der Zielfunktion identifiziert den Erdschlussort, im vorliegenden Fall an der Stelle x = 45km. Somit kann durch Minimierung der Zielfunktion ZF(x) der Erdschlussort berechnet werden. Die Suche nach dem Minimum kann mit unterschiedlichen Methoden durchgeführt werden. Insbesondere eignen sich iterative Methoden zur Optimierung der Zielfunktion. Gemäß einem möglichen Ausführungsbeispiel kann ein Simplex-Downhill-Verfahren verwendet werden, das ein sehr gutes Konvergenzverhalten aufweist und keine Ableitung der Zielfunktion nach den Modellparametern (x, jω) benötigt. Im vorliegenden Beispiel wird das Minimum bereits nach wenigen Schritten erreicht. Dies ist beispielhaft in Figur 11 gezeigt.

Im Fall, dass es sich bei dem Energieversorgungsnetz (zumindest teilweise) um ein Kabelnetz handelt und der Erdschluss von der selbstverlöschenden Art ist, kann durch zusätzliche Kenntnisse der verlegten Leitungen die Genauigkeit der Fehlerortung weiter erhöht werden. In Kabelnetzen treten selbstlöschende Erdschlüsse nämlich grundsätzlich nur an den Verbindungsstellen (sogenannte "Muffen") auf. Besitzt das Kabelnetz solche Muffen, können diese in bei der Auswertung der Fehlerortung durch Unterteilung des Kabels in mehrere Kabelsegmente berücksichtigt werden. Die Kabelsegmente werden entsprechend der Lage der Muffen festgelegt. In solchen Fällen kann ein transienter Erdschluss auch dann der Lage einer Muffen zugeordnet werden, wenn der berechnete Fehlerort nur in der Nähe der Muffe liegt, indem als der tatsächliche Fehlerort der Ort derjenigen Muffe bestimmt wird, die dem berechneten Fehlerort am nächsten liegt.

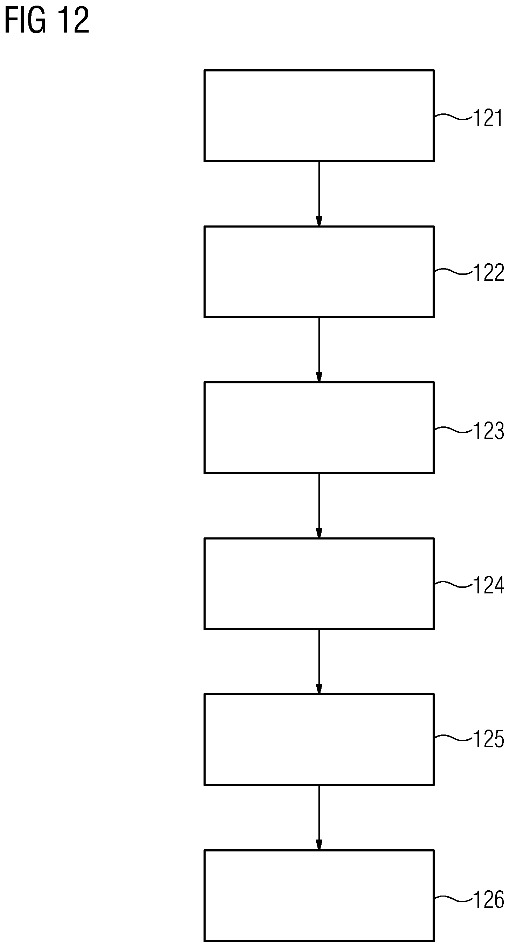

In Figur 12 ist das Verfahren zur Fehlerortung eines Erdschlusses in nicht geerdeten Netzen zusammenfassend in einem Ablaufschema dargestellt. Dabei ist darauf hinzuweisen, dass nicht alle Verfahrensschritte obligatorisch vorliegen müssen, sondern teilweise vorteilhafte Weiterbildungen des Verfahrens darstellen.

In einem ersten Schritt 121 findet zunächst eine kontinuierliche Überwachung des Energieversorgungsnetzes hinsichtlich des Auftretens eines Erdschlusses statt. Dazu werden ständig Strom- und Spannungswerte an der Messstelle aufgenommen und ausgewertet. Die Detektion eines Erdschlusses und dessen Richtung kann in bekannter Weise, z. B. mit einem Erdschlusswischer-Relais, einer Sprungdetektion oder der wattmetrischen Methode, erfolgen. Falls die Strom- und Spannungswerte auf keinen Fehler hindeuten, werden sie verworfen bzw. im Ringspeicherbetrieb mit neuen Werten überschrieben. Falls ein Erdschluss erkannt wird, werden die Strom- und Spannungswerte während des Fehlers sowie bevorzugt auch eine gewisse Zeitdauer vor und nach Fehlereintritt zur weiteren Auswertung gespeichert. Dieser optionale Schritt 121 dient dazu, das eigentliche Fehlerortungsverfahren nur dann anzustoßen, wenn tatsächlich ein Erdschluss aufgetreten ist. Sofern in Schritt 121 ein Erdschluss erkannt wird, wird das Verfahren beim folgenden Schritt 122 fortgesetzt; andernfalls wird die Überwachung auf einen Erdschluss in Schritt 121 weitergeführt.

In Schritt 122 werden die erfassten Strom- und Spannungswerte in modale Clarke-Komponenten umgewandelt. Dabei werden die α-Komponente und die 0-Komponente der Strom- und Spannungswerte gebildet. Die Fehlerortung erfolgt in modalen Clarke-Komponenten. Erfindungsgemäß wird die unterschiedliche Ausbreitungskonstante einer Welle in der α- und der 0- Komponente ausgenutzt, um eine Fehlerortung durchzuführen.

Optional kann in diesem Schritt 122 auch eine Ermittlung der erdschlussbehafteten Phase stattfinden. Dazu wird zusätzlich auch die β-Komponente der Strom- und Spannungswerte betrachtet. Hierzu werden alle drei Phasen als Referenzphasen genommen. Die Referenzphase bestimmt die Zuordnung der Parameter der Transformationsmatrix für die α-, β- und 0-Komponente. Üblicherweise werden die Parameter der Clarke-Transformation so dargestellt, dass die Referenzphase die Phase A ist. Verändert man die Position der Parameter, kann die Referenzphase beliebig verschoben werden. Es ist somit immer günstig, die Referenzphase so auszuwählen, dass sie der Erdschlussphase entspricht. Es wird daher geprüft, bei welcher Referenzphase sich der Wert der β-Komponente gegenüber dem vorhergehenden erdschlussfreien Zustand am wenigsten verändert. Diese Phase wird als erdschlussbehaftete Phase betrachtet. Die Bezugsphase für die Clarke Transformation wird damit so gewählt, dass die Amplitude der β-Komponente zu Null wird. Die α- und die 0- Komponente werden mit der so bestimmten Bezugsphase gebildet.

Die α-Komponente und die 0-Komponente werden daraufhin dem folgenden Schritt 123 übergeben. Sofern eine Auswertung hinsichtlich der erdschlussbehafteten Phase stattgefunden hat, wird auch die Information darüber an den Schritt 123 weitergegeben.

Optional kann im folgenden Schritt 123 abhängig von der Messfenstergröße eine Umwandlung der Clarketransformierten zeitlichen Verläufe der Strom- und Spannungswerte in den Frequenzbereich stattfinden. Dafür kann z. B. eine FFT verwendet werden. Alternativ kann die Fehlerortung auch im Zeitbereich stattfinden, dann wird das Verfahren nach Schritt 122 direkt bei Schritt 125 fortgesetzt.

Sofern in Schritt 123 eine Umsetzung in den Frequenzbereich stattgefunden hat, werden in Schritt 124 die für die Fehlerortung zu betrachtenden Frequenzen ausgewählt. Dabei werden nur Frequenzen oberhalb der Netzfrequenz berücksichtigt. Spektralanteile unterhalb der tiefsten Resonanzstelle werden ausgeblendet. Die Frequenzauflösung ist vom Messdatenfenster abhängig. Es werden nur die Transienten verwendet, die einerseits in einem Frequenzbereich liegen, der von den Primärwandlern fehlerarm übertragen wird und andererseits einen hohen Energieanteil der bei einem Erdschluss entstehenden Transienten enthalten. Die Anteile bei Netzfrequenz werden unterdrückt, um eine Fehlmessung durch Lastströme und Asymmetrien zu vermeiden.

In Schritt 125 werden ortsabhängige Verlaufsfunktionen der $\alpha$-Komponenten-Fehlerspannung und der 0-Komponenten-Fehlerspannung berechnet (Gleichungen (26) und (27)). Mit diesen wird eine Zielfunktion gebildet, die dazu geeignet ist, die Übereinstimmung der Verlaufsfunktion zu bewerten. Die zur Bildung der Verlaufsfunktionen verwendeten Transienten tragen das Muster des Erdschlusses mit. Aus den Messgrößen an der Messstelle am Leitungsende werden mittels eines Leitungsmodells die Fehlerspannungen in modalen $\alpha$- und 0- Komponenten an einem angenommenen Ort x auf der Leitung gebildet. Da die $\alpha$- und die 0- Komponenten unterschiedliche Ausbreitungsgeschwindigkeiten besitzen, ergibt sich eine Übereinstimmung der Verlaufsfunktionen der Fehlerspannungen nur für den tatsächlichen Fehlerort.

Beispielsweise kann die Zielfunktion die Differenz, bevorzugt die quadrierte Differenz (Gleichung (28)), zwischen 0- und $\alpha$-Komponenten-Fehlerspannungen in Abhängigkeit vom Fehlerort beschreiben. Diese Funktion wird mit einem nichtlinearen Optimierungsverfahren, z.B. dem Simplex-Downhill-Verfahren, zur Suche desjenigen Ortes entlang der Leitung optimiert, an dem die Verlaufsfunktionen die größte Übereinstimmung aufweisen. In Schritt 126 wird schließlich der in Schritt 125 aus der Optimierung hervorgegangene Ort als Fehlerort bestimmt und ausgegeben. Die Ausgabe kann z.B. lokal am Gerät erfolgen und/oder als elektronische Nachricht an eine Leitstelle übermittelt werden.

Die frequenzabhängigen Amplituden- und Phasenfehler der Primärwandler können in der Erstellung der Zielfunktion berücksichtigt werden.

Sofern es sich bei der Leitung in dem Abschnitt, auf dem der Fehlerort festgestellt wurde, um eine Kabelleitung handelt, kann durch zusätzliche Information über die Lage der Verbindungsstellen (Muffen) zwischen einzelnen Kabelsegmenten die Lage des Fehlers noch weiter eingegrenzt werden. Als Fehlerort wird dann diejenige Position einer Muffe verwendet, die dem aus der Optimierung berechneten Fehlerort am nächsten liegt.

Das oben beispielhaft beschriebene Fehlerortungsverfahren weist im Vergleich zum Stand der Technik wesentliche Vorteile auf. Zum einen kann mit dem beschriebenen Verfahren unter Verwendung der sich aus dem Erdschlussvorgang in dem Strom und in der Spannung ergebenen Transienten eine einseitige Erdschlussortung durchgeführt werden. Eine synchrone Messung an beiden Leitungsenden und die Übertragung der Messwerte zu jeweiligen Gegenende kann vorliegend somit entfallen.

Im Vergleich zu konventionellen Fehlerortungsmethoden, bei denen zur Fehlerortung genaue Erdschlussortung mit erdschlusstreuen Fundamental-Größen erfolgt, können mit der vorliegenden Methode auch Erdschlüsse von sehr kurzer Dauer geortet werden. Durch das vorgeschlagene Verfahren lässt sich das Messfenster nämlich deutlich reduzierten. Die Berechnung des Erdschlussortes erfolgt mit einem sehr kurzen Messfenster. Somit können die Erdschlüsse unter einer Periodendauer identifiziert und geortet werden.

Da die beim Erdschluss entstehenden Transienten nicht besonders hochfrequent sind, lässt sich der Algorithmus in Verbindung mit konventioneller Messtechnik der Strom- und Spannungswandler realisieren und z.B. in eine Schutzfunktion eines bestehenden Schutzgerätes integrieren. Für die Erfassung der Transienten können konventionelle z.B. Schutzwandler verwendet werden.

Als Leitungsmodell zur Berechnung des Fehlerortes kann ein vereinfachtes Modell einer verlustbehafteten Leitung mit frequenzunabhängigen Parametern verwendet werden, da Nichtlinearitäten (Skin-Effekt) erst weit oberhalb des für die Fehlerortung benutzten Frequenzbandes auftreten.

Ein weiterer Vorteil der Methode besteht darin, dass das Ergebnis der Erdschlussortung - selbst bei hochohmigen Erdschlüssen - nicht signifikant durch den Lastfluss beeinflusst wird.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln des Fehlerortes eines Erdschlusses bezüglich einer Leitung (10) eines dreiphasigen elektrischen Energieversorgungsnetzes mit nicht geerdetem Sternpunkt, bei dem

   - an einem Leitungsende (11) der Leitung (10) Strom- und Spannungswerte gemessen werden; und
   - unter Verwendung der gemessenen Strom- und Spannungswerte nach dem Auftreten eines Erdschlusses auf der Leitung (10) dessen Fehlerort bestimmt wird;
   **dadurch gekennzeichnet, dass**
   - die gemessenen Strom- und Spannungswerte unter Verwendung einer Clarke-Transformation in $\alpha$-Komponenten und 0-Komponenten der Clarke-Transformation umgesetzt werden;
   - unter Verwendung der in die $\alpha$-Komponente umgesetzten Strom- und Spannungswerte und eines Ausbreitungsmodells für Wanderwellen auf der Leitung (10) eine ortsabhängige Verlaufsfunktion von $\alpha$-Komponenten-Fehlerspannungswerten bestimmt wird;
   - unter Verwendung der in die 0-Komponente umgesetzten Strom- und Spannungswerte und des Ausbreitungsmodells für Wanderwellen auf der Leitung eine ortsabhängige Verlaufsfunktion von 0-Komponenten-Fehlerspannungswerten bestimmt wird;
   - die Übereinstimmung der beiden Verlaufsfunktionen für unterschiedliche gewählte Orte auf der Leitung ermittelt wird; und
   - derjenige gewählte Ort als Fehlerort des Erdschlusses auf der Leitung (10) bestimmt wird, bei dem die beiden Verlaufsfunktionen die stärkste Übereinstimmung aufweisen.

2. Verfahren nach Anspruch 1,
   **dadurch gekennzeichnet, dass**

   - die stärkste Übereinstimmung der beiden Verlaufsfunktionen durch Optimierung einer Zielfunktion ermittelt wird, wobei als Optimierungsgröße für die Zielfunktion der gewählte Ort auf der Leitung (10) verwendet wird.

3. Verfahren nach Anspruch 2,
   **dadurch gekennzeichnet, dass**

   - mit der Zielfunktion derjenige Ort als Fehlerort bestimmt wird, für den ein Minimum der Differenz der beiden Verlaufsfunktionen vorliegt.

4. Verfahren nach Anspruch 2 oder 3,
   **dadurch gekennzeichnet, dass**

   - bei der Bildung der Zielfunktion frequenzabhängige Amplituden- und/oder Phasenwinkelfehler von zur Erfassung der Strom- und Spannungswerte verwendeten Messwandlern (13, 14) berücksichtigt werden.

5. Verfahren nach einem der Ansprüche 2 bis 4,
   **dadurch gekennzeichnet, dass**

   - zur Optimierung ein iteratives Optimierungsverfahren verwendet wird.

6. Verfahren nach Anspruch 5,
   **dadurch gekennzeichnet, dass**

   - als Optimierungsverfahren ein Simplex-Downhill-Verfahren verwendet wird.

7. Verfahren nach einem der vorangehenden Ansprüche,
   **dadurch gekennzeichnet, dass**

   - die gemessenen Strom- und Spannungswerte unter Verwendung der Clarke-Transformation auch in $\beta$-Komponenten der Clarke-Transformation umgesetzt werden;
   - die $\beta$-Komponenten der Strom- und/oder Spannungsmesswerte der einzelnen Phasen miteinander verglichen werden; und
   - diejenige Phase als von dem Erdschluss betroffen ermittelt wird, für die die $\beta$-Komponenten der vor dem Fehlereintritt gemessenen Strom- und/oder Spannungsmesswerte im Vergleich zu den β-Komponenten der nach dem Fehlereintritt gemessenen Strom- und/oder Spannungsmesswerte die geringste Änderung aufweisen.

8. Verfahren nach Anspruch 7,
   **dadurch gekennzeichnet, dass**

   - der Fehlerort ausschließlich für die von dem Erdschluss betroffene Phase bestimmt wird.

9. Verfahren nach einem der vorangehenden Ansprüche,
   **dadurch gekennzeichnet, dass**

   - die in die α-Komponente und die in die 0-Komponente der Clarke-Transformation umgesetzten Strom- und Spannungsmesswerte einer Transformation in den Frequenzbereich unterzogen werden; und
   - die Bestimmung des Fehlerortes innerhalb eines ausgewählten Frequenzbereichs durchgeführt wird, der oberhalb der Netzfrequenz des Energieversorgungsnetzes liegt.

10. Verfahren nach Anspruch 9,
    **dadurch gekennzeichnet, dass**

    - der ausgewählte Frequenzbereich bandbegrenzte transiente Anteile der α- und der 0-Komponente der gemessenen Strom- und Spannungswerte, vorzugsweise einen Frequenzbereich von 600 Hz bis 15 kHz, umfasst.

11. Verfahren nach einem der vorangehenden Ansprüche,
    **dadurch gekennzeichnet, dass**

    - die gemessenen Strom- und Spannungswerte vor der Durchführung der Clarke-Transformation einer Filterung unterzogen werden, wobei als Filter ein Tiefpassfilter verwendet wird.

12. Verfahren nach einem der vorangehenden Ansprüche,
    **dadurch gekennzeichnet, dass**

    - die Leitung (10) kontinuierlich auf das Auftreten eines Erdschlusses überwacht wird; und
    - die Bestimmung des Fehlerortes ausschließlich dann durchgeführt wird, wenn ein Erdschluss bezüglich der Leitung (10) erkannt worden ist.

13. Verfahren nach Anspruch 12,
    **dadurch gekennzeichnet, dass**

    - das Vorliegen eines Erdschlusses dann erkannt wird, wenn im Verlauf der Strom- und Spannungswerte oder davon abgeleiteten Werten ein Sprung festgestellt worden ist, der eine vorgegebene Schwelle übersteigt, oder wenn ein für einen Erdschluss charakteristisches Verhalten eines Summennullstroms und einer Verlagerungsspannung vorliegt.

14. Verfahren nach einem der vorangehenden Ansprüche,
    **dadurch gekennzeichnet, dass**

    - bei einer Leitung (10) in Form eines aus mehreren Segmenten zusammengesetzten Kabels diejenige Verbindungstelle zwischen zwei Segmenten des Kabels als tatsächlicher Fehlerort eines selbstlöschenden Erdfehlers bestimmt wird, die dem bei der Optimierung der Zielfunktion bestimmten Fehlerort am nächsten liegt.

15. Einrichtung (15) zum Ermitteln des Fehlerortes eines Erdschlusses bezüglich einer Leitung (10) eines dreiphasigen elektrischen Energieversorgungsnetzes mit nicht geerdetem Sternpunkt, mit

    - einer Recheneinrichtung, die dazu eingerichtet ist, unter Verwendung von an einem Leitungsende (11) der Leitung (10) gemessenen ersten Strom- und Spannungswerten nach dem Auftreten eines Erdschlusses auf der Leitung (10) dessen Fehlerort zu bestimmen;
    **dadurch gekennzeichnet, dass**
    - die Recheneinrichtung dazu eingerichtet ist, die gemessenen Strom- und Spannungswerte unter Verwendung einer Clarke-Transformation in α-Komponenten und 0-Komponenten der Clarke-Transformation umzusetzen;
- die Recheneinrichtung dazu eingerichtet ist, unter Verwendung der in die α-Komponente umgesetzten Strom- und Spannungswerte und eines Ausbreitungsmodells für Wanderwellen auf der Leitung eine ortsabhängige Verlaufsfunktion von α-Komponenten-Fehlerspannungswerten zu bestimmen;
- die Recheneinrichtung dazu eingerichtet ist, unter Verwendung der in die 0-Komponente umgesetzten Strom- und Spannungswerte und des Ausbreitungsmodells für Wanderwellen auf der Leitung eine ortsabhängige Verlaufsfunktion von 0-Komponenten-Fehlerspannungswerten zu bestimmen;
- die Recheneinrichtung dazu eingerichtet ist, die Übereinstimmung der beiden Verlaufsfunktionen für unterschiedliche gewählte Orte auf der Leitung (10) zu ermitteln; und
- die Recheneinrichtung dazu eingerichtet ist, denjenigen gewählten Ort als tatsächlichen Fehlerort des Erdschlusses auf der Leitung (10) zu bestimmen, bei dem die beiden Verlaufsfunktionen die stärkste Übereinstimmung aufweisen.

**Claims**

1. Method for determining the fault location of a ground fault relating to a line (10) of a three-phase electrical energy supply network with an ungrounded neutral point, in which

   - current and voltage values are measured at one line end (11) of the line (10); and
   - following the occurrence of a ground fault on the line (10), the fault location of said fault is defined using the measured current and voltage values,
   **characterized in that**
   - the measured current and voltage values are converted using a Clarke transformation into α-components and 0-components of the Clarke transformation;
   - a location-dependent characteristic function of α-component fault voltage values is defined using the current and voltage values converted into the α-component and a propagation model for travelling waves on the line (10);
   - a location-dependent characteristic function of 0-component fault voltage values is defined using the current and voltage values converted into the 0-component and a propagation model for travelling waves on the line;
   - the matching of the two characteristic functions for different selected locations on the line is determined, and
   - the selected location where the two characteristic functions reveal the closest match is defined as the fault location of the ground fault on the line (10).

2. Method according to Claim 1,
   **characterized in that**

   - the closest match of the two characteristic functions is determined through optimization of a target function, wherein the selected location on the line (10) is used as the optimization variable for the target function.

3. Method according to Claim 2,
   **characterized in that**

   - the location for which a minimum of the difference between the two characteristic functions occurs is defined with the target function as the fault location.

4. Method according to Claim 2 or 3,
   **characterized in that**

   - in the formation of the target function, frequency-dependent amplitude and/or phase angle errors can be taken into account by measuring transformers (13, 14) used to measure the current and voltage value.

5. Method according to one of Claims 2 to 4,
   **characterized in that**

   - an iterative optimization method is used for the optimization.

6. Method according to Claim 5,
   **characterized in that**

- a simplex downhill method is used as the optimization method.

7.  Method according to one of the preceding claims,
    **characterized in that**

    - the measured current and voltage values are converted using the Clarke transformation into β-components of the Clarke transformation also;
    - the β-components of the current and/or voltage measured values of the individual phases are compared with one another; and
    - the phase for which the β-components of the current and/or voltage measured values measured before the fault occurrence compared with the β-components of the current and/or voltage measured values measured after the fault occurrence reveal the smallest change is determined as affected by the ground fault.

8.  Method according to Claim 7,
    **characterized in that**

    - the fault location is defined only for the phase affected by the ground fault.

9.  Method according to one of the preceding claims,
    **characterized in that**

    - the current and voltage measured values converted into the α-component and into the 0-component of the Clarke transformation are subjected to a transformation into the frequency range; and
    - the definition of the fault location is carried out within a selected frequency range which is higher than the network frequency of the energy supply network.

10. Method according to Claim 9,
    **characterized in that**

    - the selected frequency range comprises band-limited transient components of the α-component and the 0-component of the measured current and voltage values, preferably a frequency range from 600 Hz to 15 kHz.

11. Method according to one of the preceding claims,
    **characterized in that**

    - the measured current and voltage values are subjected to a filtering before the performance of the Clarke transformation, wherein a low-pass filter is used as the filter.

12. Method according to one of the preceding claims,
    **characterized in that**

    - the line (10) is monitored continuously for the occurrence of a ground fault; and
    - the definition of the fault location is carried out only if a ground fault relating to the line (10) has been detected.

13. Method according to Claim 12,
    **characterized in that**

    - the presence of a ground fault is detected if a jump which exceeds a predefined threshold has been identified in the characteristic of the current and voltage values or values derived therefrom, or if a behavior of a zero-sequence current sum and a displacement voltage of a characteristic of a ground fault occurs.

14. Method according to one of the preceding claims,
    **characterized in that**

    - in the case of a line (10) in the form of a cable made up of a plurality of segments, the connection point between two segments of the cable which is closest to the fault location defined in the optimization of the target function is defined as the actual fault location of a self-extinguishing ground fault.

**15.** Device (15) for determining the fault location of a ground fault relating to a line (10) of a three-phase electrical energy supply network with an ungrounded neutral point, with

- a processing device which is configured, following the occurrence of a fault on the line (10), to define the fault location of said fault using first current and voltage values measured at one end (11) of the line (10);
**characterized in that**
- the processing device is configured to convert the measured current and voltage values using a Clarke transformation into $\alpha$-components and 0-components of the Clarke transformation;
- the processing device is configured to define a location-dependent characteristic function of $\alpha$-component fault voltage values using the current and voltage values converted into the $\alpha$-component and a propagation model for travelling waves on the line;
- the processing device is configured to define a location-dependent characteristic function of 0-component fault voltage values using the current and voltage values converted into the 0-component and the propagation model for travelling waves on the line;
- the processing device is configured to determine the matching of the two characteristic functions for different selected locations on the line (10); and
- the processing device is configured to define the selected location where the two characteristic functions reveal the closest match as the fault location of the ground fault on the line (10).

**Revendications**

**1.** Procédé de détermination de l'emplacement d'un défaut de contact à la terre en ce qui concerne une ligne (10) d'un réseau d'alimentation en énergie électrique triphasé à point neutre non mis à la terre, dans lequel

- on mesure des valeurs de courant et de tension à un bout (11) de la ligne (10); et
- en utilisant les valeurs de courant et de tension, qui ont été mesurées, on détermine, après l'apparition d'un contact de terre sur la ligne (10), son emplacement de défaut ;
**caractérisé en ce que**
- on transforme, en utilisant une transformation de Clarke, les valeurs de courant et de tension, qui ont été mesurées, en des composantes $\alpha$ et des composantes 0 de la transformation de Clarke ;
- en utilisant les valeurs de courant et de tension transformées en des composantes $\alpha$ et un modèle de propagation d'ondes progressives sur la ligne (10), on détermine une fonction de variation, en fonction de l'emplacement, de valeurs de tension de défaut de composante $\alpha$ ;
- en utilisant les valeurs de courant et de tension transformées en des composantes 0 et un modèle de propagation d'ondes progressives sur la ligne (10), on détermine une fonction de variation, en fonction de l'emplacement, de valeurs de tension de défaut de composante 0 ;
- on détermine la coïncidence des deux fonctions de variation pour des emplacements choisis différemment sur la ligne et
- on détermine, comme emplacement du défaut de contact de terre sur la ligne (10), l'emplacement choisi, pour lequel les deux fonctions de variation ont la coïncidence la plus grande.

**2.** Procédé suivant la revendication 1,
**caractérisé en ce que**

- on détermine, par optimisation d'une fonction cible, la coïncidence la plus grande des deux fonctions de variation, en utilisant, comme grandeur d'optimisation de la fonction cible, l'emplacement choisi sur la ligne (10).

**3.** Procédé suivant la revendication 2,
**caractérisé en ce que**

- on détermine, comme emplacement de défaut par la fonction cible, l'emplacement, qui a un minimum de la différence des deux fonctions de variation.

**4.** Procédé suivant la revendication 2 ou 3,
**caractérisé en ce que**

- dans la formation de la fonction cible, on prend en compte des défaut d'amplitude et/ou d'angle de phase, en fonction de la fréquence, de transducteurs (13, 14) de mesure utilisés pour la détection des valeurs de courant et de tension.

5. Procédé suivant l'une des revendications 2 à 4,
**caractérisé en ce que**

- pour l'optimisation, on utilise un procédé d'optimisation par itération.

6. Procédé suivant la revendication 5,
**caractérisé en ce que**

- comme procédé d'optimisation, on utilise un procédé Simplex-Downhill.

7. Procédé suivant l'une des revendications précédentes,
**caractérisé en ce que**

- on transforme, en utilisant la transformation de Clarke, les valeurs de courant et de tension, qui ont été mesurées, également en des composantes $\beta$ de la transformation de Clarke ;
- on compare entre elles les composantes $\beta$ des valeurs de mesure de courant et/ou de tension des diverses phases ; et
- on détermine, comme concernée par le contact de terre, la phase pour laquelle les composantes $\beta$ des valeurs de mesure de courant et/ou de tension mesurées avant l'apparition des défauts, ont, par rapport aux composantes $\beta$ des valeurs de mesure de courant et/ou de tension mesurées après l'apparition des défauts, la variation la plus petite.

8. Procédé suivant la revendication 7,
**caractérisé en ce que**

- on détermine l'emplacement du défaut exclusivement pour la phase concernée par le contact de terre.

9. Procédé suivant l'une des revendications précédentes,
**caractérisé en ce que**

- on soumet, à une transformation dans le domaine fréquentiel, les valeurs de mesure de courant et de tension transformées en les composantes $\alpha$ et en les composantes 0 de la transformation de Clarke ; et
- on effectue la détermination de l'emplacement du défaut dans une plage de fréquence sélectionnée, qui est au-dessus de la fréquence du réseau d'alimentation en énergie.

10. Procédé suivant la revendication 9,
**caractérisé en ce que**

- la plage de fréquence sélectionnée comprend des parties transitoires limitées en bande des composantes $\alpha$ et des composantes 0 des valeurs de courant et de tension, qui ont été mesurées, de préférence, une plage de fréquence allant de 600 Hz à 15 kHz.

11. Procédé suivant l'une des revendications précédentes,
**caractérisé en ce que**

- on soumet à un filtrage, avant d'effectuer la transformation de Clarke, les valeurs de courant et de tension, qui ont été mesurées, en utilisant, comme filtre, un filtre passe bas.

12. Procédé suivant l'une des revendications précédentes,
**caractérisé en ce que**

- on contrôle continuellement l'apparition d'un contact de terre sur la ligne (10) ; et
- on effectue la détermination de l'emplacement du défaut exclusivement lorsqu'un contact de terre, concernant la ligne (10), a été détecté.

**13.** Procédé suivant la revendication 12,
   **caractérisé en ce que**

   - on détecte la présence d'un contact de terre s'il a été constaté, dans la courbe des valeurs de courant et de tension ou dans des valeurs, qui en sont déduites, un saut, qui dépasse un seuil donné à l'avance, ou s'il y a un comportement, caractéristique d'un contact de terre, d'un courant de somme nulle et d'une tension de blocage.

**14.** Procédé suivant l'une des revendication précédentes,
   **caractérisé en ce que**

   - pour une ligne (10) sous la forme d'un câble composé de plusieurs segments, on détermine, comme emplacement de défaut réel d'un défaut à la terre non rémanent, le point de liaison, qui est le plus près de l'emplacement du défaut déterminé dans l'optimisation de la fonction cible.

**15.** Dispositif (15) de détermination de l'emplacement d'un défaut de contact à la terre en ce qui concerne une ligne (10) d'un réseau d'alimentation en énergie électrique triphasé à point neutre non mis à la terre, comprenant

   - un dispositif d'ordinateur, conçu pour déterminer, en utilisant des premières valeurs de courant et de tension mesurées à un bout (11) de la ligne (10), après l'apparition d'un contact de terre sur la ligne (10), son emplacement de défaut ;
   **caractérisé en ce que**
   - le dispositif d'ordinateur est conçu pour transformer, en utilisant une transformation de Clarke, des valeurs de courant et de tensions, qui ont été mesurées, en des composantes $\alpha$ et des composantes 0 de la transformation de Clarke ;
   - le dispositif d'ordinateur est conçu pour, en utilisant les valeurs de courant et de tension transformées en des composantes $\alpha$ et un modèle de propagation d'ondes progressives sur la ligne, déterminer une fonction de variation, en fonction de l'emplacement, de valeurs de tension de défaut de composante $\alpha$ ;
   - le dispositif d'ordinateur est conçu pour, en utilisant les valeurs de courant et de tension transformées en des composantes 0 et un modèle de propagation d'ondes progressives sur la ligne, déterminer une fonction de variation, en fonction de l'emplacement, de valeurs de tension de défaut de composante 0 ;
   - le dispositif d'ordinateur est conçu pour déterminer la coïncidence des deux fonctions de variation pour des emplacements choisis différemment sur la ligne (10) ; et
   - le dispositif d'ordinateur est conçu pour déterminer, comme emplacement réel du défaut du contact de terre sur la ligne (10), l'emplacement choisi, pour lequel les deux fonctions de variation ont la coïncidence la plus grande.

## FIG 1

## FIG 2

EP 3 351 949 B1

**FIG 3**

FIG 4

α-Mode

0-Mode

$I_{A\alpha}$  $U_{A\alpha}$  41c  41a  41b

$I_{A0}$  $U_{A0}$  42c  42a  42b

F

FIG 5

# FIG 6

FIG 7

EP 3 351 949 B1

FIG 8

FIG 9

EP 3 351 949 B1

## FIG 10

EP 3 351 949 B1

FIG 11

Fehlerort [km]

Iterationsschritte [–]

EP 3 351 949 B1

## FIG 12

**IN DER BESCHREIBUNG AUFGEFÜHRTE DOKUMENTE**

**In der Beschreibung aufgeführte Patentdokumente**

- EP 2476002 B1
- WO 2012126526 A1
- US 4996624 A
- US 5929642 A
- US 2011098951 A1
- US 8655609 B2